# EUROPÄISCHE PATENTSCHRIFT

(11) **EP 3 834 591 B1**
(45) Veröffentlichungstag und Bekanntmachung des Hinweises auf die Patenterteilung: **19.01.2022**
(21) Anmeldenummer: 19739991.8
(22) Anmeldetag: 15.07.2019
(51) Int. Cl.: H05K 7/14, H02S 40/32

(54) **ZWISCHENKREISANORDNUNG UND WECHSELRICHTER**
INTERMEDIATE CIRCUIT ARRANGEMENT AND INVERTER
AGENCEMENT DE CIRCUIT INTERMÉDIAIRE ET ONDULEUR

(30) Priorität: 09.08.2018 DE 202018104586 U
(43) Veröffentlichungstag der Anmeldung: 16.06.2021
(73) Patentinhaber: SMA Solar Technology AG, 34266 Niestetal (DE)
(72) Erfinder: KLAUSZ, Zoltan, 34302 Guxhagen (DE); HARBUSCH, Ralf, 34393 Grebenstein (DE)
(86) Internationale Anmeldenummer: PCT/EP2019/069005
(87) Internationale Veröffentlichungsnummer: WO 2020/030383

(56) Entgegenhaltungen:
- WO-A1-2018/091021
- US-A1- 2018 116 065

## Beschreibung

Die Erfindung betrifft Zwischenkreisanordnung, sowie einen Wechselrichter mit einer derartigen Zwischenkreisanordnung.

Zwischenkreise finden sich regelmäßig eingangsseitig einer Wechselrichterbrücke als kurzzeitige Energiespeicher für die zu wandelnde elektrische Leistung in einem Wechselrichter. Sie werden gebildet durch Kondensatoren beziehungsweise Kondensatorbänke, die zwischen einem positiven Zwischenkreisanschluss und einem negativen Zwischenkreisanschluss angeordnet sind. Um die erforderlichen Kapazitätswerte zu erreichen, werden eine Vielzahl einzelner Kondensatoren oder gar eine Mehrzahl von Kondensatorbänken parallel geschaltet. Die Kondensatorbänke können dabei auf unterschiedlichen Leiterplatten angeordnet sein.

Gerade bei Multilevel-Wechselrichterbrücken werden hierbei noch mehrere Kondensatorbänke in Reihe geschaltet. Die Verbindungspunkt zwischen den in der Reihe geschalteten Kondensatorbänken stellen dann Zwischenwerte der Eingangsspannung bereit. Üblich werden zwei, drei oder sogar vier Kondensatorbänke hierbei in Reihe geschaltet, um neben der positiven und negativen Zwischenkreisspannung noch einen, zwei oder drei zusätzliche Spannungswerte für die Multilevel-Wechselrichterbrücke bereitzustellen.

Das Dokument US 2018/0116065 A1 beschreibt eine leistungselektronischen Vorrichtung mit einer Zwischenkreisanordnung, die eine abgeschirmte Busstruktur aufweist. Die abgeschirmte Busstruktur dient dazu, die Abstrahlung elektromagnetischer Störstrahlung zu vermeiden, die durch eine schnell taktende Brücke der leistungselektronischen Vorrichtung verursacht wird.

In dem Dokument WO 2018/091021 A1 ist eine durch einen Blechstapel gebildete Busstruktur offenbart. Der Blechstapel wird durch bevorzugt als Gleichteile ausgebildete Stanzteile gebildet, wobei abwechselnd ein Blech, das mit einem positiven Pol verbunden ist, auf einem Blech, das mit einem negativen Pol verbunden ist, angeordnet wird, wobei die beiden Bleche jeweils durch eine Isolation elektrisch voneinander getrennt sind. Die Busstruktur kann als Winkelelement gebildet werden, das zwei Platinen, beispielsweise ein Kondensatormodul mit einem Leistungsmodul, elektrisch miteinander verbindet.

Da über die verschiedenen Anschlüsse einer vorstehend beschriebenen Zwischenkreisanordnung teilweise hohe Ströme fließen, ist eine aufwändige Verbindungstechnik für die Zwischenkreisanordnung erforderlich. Gleichzeitig ist es wünschenswert, dass Kondensatorbänke, die auf unterschiedlichen Leiterplatten angeordnet sind, möglichst baugleich ausgeführt werden können, um die Zahl unterschiedlicher Bauteile in einem Wechselrichter gering zu halten.

Es ist demzufolge Aufgabe dieser Erfindung, eine Zwischenkreisanordnung beziehungsweise einen Wechselrichter aufzuzeigen, bei denen baugleich ausgeführte Teilplatinen mit Kondensatorbänken aufwandsarm und impedanzarm miteinander und mit weiteren Bauteilen eines elektrischen Geräts, insbesondere eines Wechselrichters, verbunden werden können.

Diese Aufgabe wird gelöst durch eine Zwischenkreisanordnung mit den Merkmalen des unabhängigen Anspruchs 1. Bevorzugte Ausführungsformen der Zwischenkreisanordnung sind in den abhängigen Ansprüchen beschrieben. Die Aufgabe wird weiterhin gelöst durch einen Wechselrichter mit einer solchen Zwischenkreisanordnung nach Anspruch 8 wobei bevorzugte Ausführungsformen des Wechselrichters in den auf Anspruch 8 zurückbezogenen Ansprüchen beschrieben sind.

Eine erfindungsgemäße Zwischenkreisanordnung umfasst baugleiche erste und zweite Teilplatinen mit einer Reihenschaltung von mindestens zwei Kapazitätsbänken, wobei die Teilplatinen jeweils eine Anschlussleiste mit jeweils einem positiven Zwischenkreisanschluss, einem negativen Zwischenkreisanschluss, einem Mittenanschluss aufweisen. Eine Verbindungsplatine zur elektrischen Verbindung jeweiliger Anschlüsse der Anschlussleisten beider Teilplatinen miteinander ist als Mehrlagenplatine mit zwei äußeren Metalllagen und mindestens zwei zwischen den äußeren Metalllagen angeordneten inneren Metalllagen ausgebildet, wobei die äußeren Metalllagen eine elektrische Verbindung jeweils zwischen korrespondierenden Anschlüssen der Anschlussleisten der beiden Teilplatinen aufweisen, und wobei mindestens eine erste Metalllage der inneren Metalllagen nur eine elektrische Verbindung der positiven Zwischenkreisanschlüsse der beiden Teilplatinen und mindestens eine zweite Metalllage der inneren Metalllagen nur eine elektrische Verbindung der negativen Zwischenkreisanschlüsse der beiden Teilplatinen aufweisen.

Die Teilplatinen weisen bevorzugt eine Reihenschaltung von vier Kapazitätsbänken, sowie deren Anschlussleisten weiterhin einen positiven Halbanschluss und einen negativen Halbanschluss auf, wobei die äußeren Metalllagen weiterhin eine elektrische Verbindung jeweils zwischen den positiven Halbanschlüssen und zwischen den negativen Halbanschlüssen der beiden Teilplatinen aufweisen. Durch die Aufteilung in vier Kapazitätsbänke können zum einen Kondensatoren mit niedrigerer zulässiger Maximalspannung verwendet werden, zum anderen können auch Wechselrichterbrücken mit mehr Spannungsniveaus, beispielsweise in diesem Fall eine 5-Level-Wechselrichterbrücke, an einen durch die Reihenschaltung gebildeten Zwischenkreis angeschlossen werden.

Vorteilhafterweise weisen die Verbindungsplatine elektrische Kontaktflächen mit Bohrungen auf, über die die Verbindungplatine jeweils mit korrespondierenden Bohrungen in den Kontaktflächen der Anschlussleisten der Teilplatinen mit diesen verschraubbar und dadurch elektrisch kontaktierbar ist. Eine solche Verbindungstechnik hat sich in der Fertigung als aufwandsarm und zuverlässig bei hoher Stromtragfähigkeit erwiesen.

Die Verschraubung der Verbindungsplatine kann mit den jeweiligen Teilplatinen zusätzlich zur Halterung der Zwischenkreisanordnung in einem Gehäuse oder auf einer Leiterplatte dienen. Hierbei kann die Verschraubung der Zwischenkreisanordnung mit einem im Gehäuse fest angebrachten Gewinde aus elektrisch isolierendem Material, beispielsweise Kunststoff erfolgen. Eine zusätzliche Halterung der Zwischenkreisanordnung an anderen Punkten im Gehäuse ist selbstverständlich nicht ausgeschlossen.

Zusätzlich können Anschlussleitungen für eine Spannungsquelle über Kabelschuhe zumindest mit dem positiven und dem negativen Zwischenkreisanschluss verschraubt sein.

In einer bevorzugten Gestaltung weist jeder der beiden Teilplatinen auf gegenüberliegenden Seiten jeweils eine Anschlussleiste (4) auf, die insbesondere auf gleicher Höhe zueinander angeordnet sind. Hierdurch kann die elektrische Verbindung zwischen den einzelnen Anschlüssen nebeneinander angeordneter Teilplatinen über die Verbindungsplatine auf besonders kurzem Wege und damit besonders impedanzarm ausgeführt sein. Es verbleiben dann nicht genutzte Anschlussleisten der beiden Teilplatinen.

In einer besonders vorteilhaften Ausführung weisen die Teilplatinen weiterhin mindestens eine Brückenschaltung auf, dessen Eingangsanschlüsse mit den Zwischenkreisanschlüssen der Teilplatine verbunden sind. Beispielsweise können auf einer Teilplatine jeweils drei Brückenschaltungen angeordnet sein, deren Brückenausgänge jeweils Phasenanschlüsse zum Anschluss an ein dreiphasiges Wechselstromnetz bilden. Selbstverständlich kann eine erfindungsgemäße Zwischenkreisanordnung auch keine Brückenschaltungen auf den Teilplatinen aufweisen.

In einer weiteren vorteilhaften Ausführungsform weist die Verbindungsplatine eine Mehrzahl innerer Metalllagen auf, die zueinander benachbart angeordnet sind, und über die die positiven Zwischenkreisanschlüsse der beiden Teilplatinen miteinander verbunden sind. Entsprechend können auch die negativen Zwischenkreisanschlüsse der beiden Teilplatinen über eine Mehrzahl innerer Metalllage miteinander verbunden sein, die ebenfalls zueinander benachbart angeordnet sind. Durch diese gruppenweise Anordnung kann eine vorteilhaft niederimpedante Verbindung zwischen den Teilplatinen erreicht werden.

In einer besonders vorteilhaften Ausführung weist ein Wechselrichter eine vorstehend beschriebenen Zwischenkreisanordnung auf. In dieser Ausführung kann jede der Teilplatinen mindestens eine Brückenschaltung aufweisen, besonders bevorzugt weist jede Teilplatine genau drei Brückenschaltungen auf. Die Ausgänge dieser Brückenschaltungen bildenden jeweils einen Phasenanschluss zum Anschluss an ein Wechselspannungsnetz.

Im Falle von drei Brückenschaltungen je Teilplatine ist es vorteilhaft, auf jeder Teilplatine jeweils zwei der Brückenschaltungen einer gemeinsamen Phase eines dreiphasigen Wechselspannungsausgangs zuzuordnen. Die beiden verbleibenden einzelnen Phasenanschlüsse beider Teilplatinen, bevorzugt die Phasenanschlüsse der beiden Teilplatinen, die den geringsten Abstand voneinander aufweisen, also die inneren Phasenanschlüsse, werden dann zur gemeinsamen dritten Phase des Wechselspannungsausgangs zusammengefasst. Auf diese Weise können die drei Phasenausgänge leicht räumlich getrennt voneinander im Gehäuse geführt und mit weiteren Komponenten wie Netzdrosseln verbunden werden.

Die Erfindung wird im Folgenden mithilfe von Figuren illustriert, von denen
Fig. 1 eine Ausführung einer Teilplatine einer erfindungsgemäßen Zwischenkreisanordnung,
Fig. 2 eine erfindungsgemäße Ausführung einer Zwischenkreisanordnung; und
Fig. 3 einen Querschnitt durch eine Verbindungsplatine einer erfindungsgemäßen Zwischenkreisanordnung zeigen.

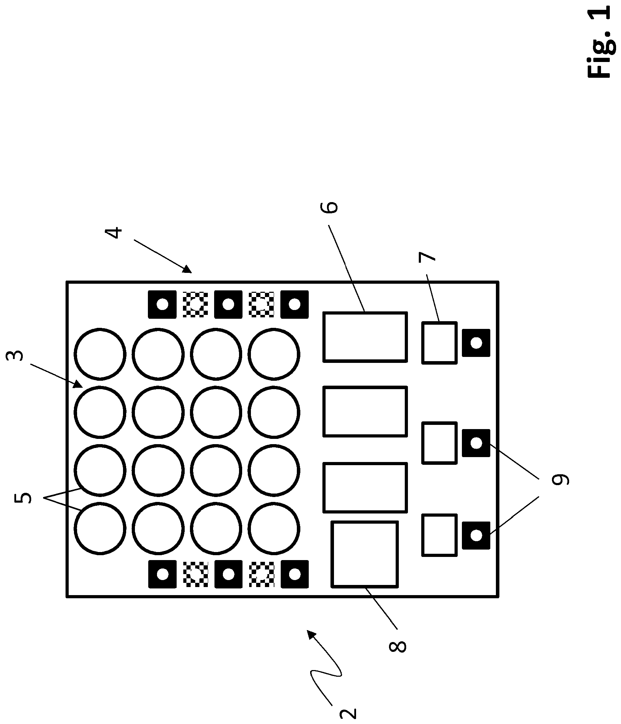

Fig. 1 zeigt eine Teilplatine 1 zum Aufbau einer erfindungsgemäßen Zwischenkreisanordnung. Die Teilplatine weist eine Vielzahl von Kondensatoren 5 auf, die zu in Reihe geschalteten Kapazitätsbänken 3 zusammengefasst sind. Die Kapazitätsbänke 3 dienen als eingangsseitiger Zwischenkreis zum Beispiel für eine oder mehrere Wechselrichterbrücken, die in Form von Leistungsmodulen 6 auf der Teilplatine 2 angeordnet sind. Ausgangsseitig sind die Wechselrichterbrücken in dieser Ausführung jeweils über Stromsensoren 7 an den Wechselrichterbrücken zugeordnete Phasenanschlüsse 9 angeschlossen. Eine Steuerung 8 steuert die Leistungsmodule 6 im Betrieb an und empfängt die Messsignale der Stromsensoren 7.

Auf einander gegenüberliegenden Seiten der Teilplatine 2 sind Anschlussleisten 4 angeordnet, die mit Anschlüssen der Kapazitätsbänke 3 elektrisch verbunden sind. Im Fall von zwei in Reihe geschalteten Kapazitätsbänken 3 umfasst die Anschlussleiste 4 drei Anschlusskontakte, die jeweils eine mittige Bohrung aufweisen und von denen jeweils ein Anschlusskontakt mit einem der beiden Endanschlüssen der Reihenschaltung der Kapazitätsbänke und ein Anschlusskontakt mit dem Mittelpunkt der Reihenschaltung verbunden sind. Sofern die Reihanschaltung mehr als zwei Kapazitätsbänke aufweist, umfasst die Anschlussleiste 4 entsprechend mehr Anschlusskontakte, die jeweils mit den weiteren Zwischenpunkten zwischen den Kapazitätsbänken elektrisch verbunden sind. So sind bei einer Reihenschaltung von vier Kapazitätsbänken 3 dann fünf Anschlusskontakte in der Anschlussleiste 4 erforderlich. Die beiden zusätzlichen optionalen Anschlusskontakte sind daher schattiert gezeichnet.

Die Anschlussleisten 4 sind auf den gegenüberliegenden Seiten der Teilplatine 2 auf gleicher Höhe und entlang einer Ausrichtungsachse angeordnet, so dass die Anschlusskontakte von zwei nebeneinander angeordneten Teilplatine 2 leicht über eine Verbindungsplatine miteinander und beispielsweise mit einer Spannungsquelle elektrisch verbunden werden können. Selbstverständlich sind auch andere Anordnungen, beispielsweise eine versetzte Anordnung der Kontaktflächen, denkbar.

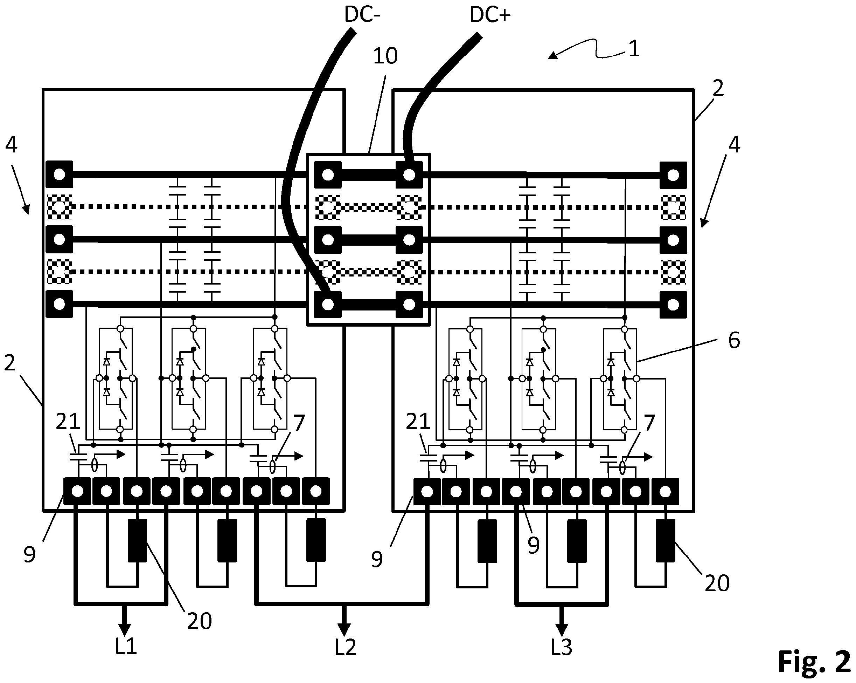

Eine solche Zwischenkreisanordnung 1 ist in Fig. 2 gezeigt. Die einander gegenüberliegenden Anschlussleisten 4 von zwei Teilplatinen 2 sind von einer Verbindungsplatine 10 überdeckt, deren Anschlusskontakte ausgerichtet über den Anschlusskontakten auf den beiden Teilplatinen 2 liegen. Hierdurch können beispielsweise Schrauben durch die ausgerichteten Bohrungen von Verbindungplatine 10 und Teilplatine 2 geführt werden, so dass die Kontaktflächen der Anschlusskontakte von Verbindungplatine 10 und Teilplatine 2 durch die Verschraubung aufeinander gepresst werden und einen zuverlässigen elektrischen Kontakt herstellen. Mit den Schrauben können auch Kabelschuhe mit den Anschlusskontakten verschraubt und elektrisch verbunden werden, so dass beispielsweise eine Spannungsquelle wie ein Photovoltaikgenerator über Kabel an die Teilplatinen 2 angeschlossen werden können. Symbolisch sind zwei Anschlusskabel für die Anschlüsse DC+, DC- der Spannungsquelle gezeigt. Die Schrauben können hierbei auch zum Beispiel in ein elektrisch isolierendes Gewinde eingeschraubt werden, wobei das Gewinde fest mit einem Gehäuse verbunden ist. Auf diese Weise kann gleichzeitig auch eine Haltefunktion für die gesamte Zwischenkreisanordnung realisiert werden.

Weiterhin zeigt die Fig. 2 beispielhaft eine Anordnung von vier in Reihe geschalteten Kapazitätsbänken 3, sowie eine NPC-Wechselrichterbrücke als Leistungsmodul 6. Andere Wechselrichterbrücken-Topologien sind selbstverständlich ebenfalls verwendbar. Die Brückenausgänge der Leistungsmodule 6 werden hier zunächst jeweils über einen ersten AC-Anschluss mit einem Anschluss einer aus Platzgründen nicht auf den Teilplatinen angeordneten Drossel 20 als Teil eines Netzfilters verbunden, deren anderen Anschluss wiederum mit einem zugeordneten zweiten AC-Anschluss verbunden ist. Der zweite AC-Anschluss ist wiederum über einen Stromsensor 7 mit einem der jeweiligen Wechselrichterbrücke 6 zugeordneten Phasenanschluss 9 verbunden. Von dieser Verbindung zweigt jeweils noch ein auf der Teilplatine angeordneter Kondensator 21 als weiterer Teil des Netzfilters ab. Die Kondensatoren 21 werden mit einem Anschluss gemeinsam mit dem Mittelpunkt der Reihenschaltung der Zwischenkreisanordnung verbunden.

Die Phasenanschlüsse der beiden Teilplatinen 2 sind zum Anschluss an ein dreiphasiges Netz mit Phasen L1, L2 und L3 derart zusammengefasst, dass jeweils zwei Phasenanschlüsse einer Teilplatine 2 eine Phase L1, L3 bilden und nur die Phase L2 durch Phasenanschlüsse beider Teilplatinen 2 gebildet wird. In den Phasen L1, L2, L3 können weitere Drosseln als Netzfilter-Komponente integriert sein (nicht gezeigt).

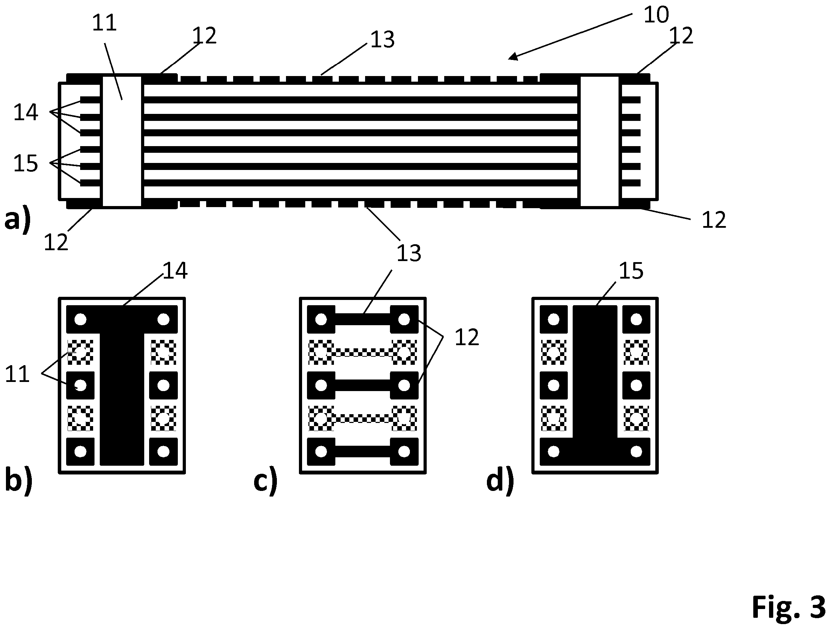

Ein struktureller Aufbau der Verbindungsplatine 10 ist in größerem Detail in der Fig. 3 gezeigt, wobei die Fig. 3a einen Querschnitt durch eine Verbindungsplatine 10 zeigt, während die Figuren 3b, 3c und 3d den Aufbau unterschiedlicher Metalllagen innerhalb der Verbindungsplatine 10 zeigen.

Die Verbindungsleitung 10 ist hierbei als Mehrlagen-Leiterplatte aufgebaut, die zwei äußere Metalllagen 13 auf gegenüberliegenden Außenseiten der Leiterplatte, sowie eine Mehrzahl innerer Metalllagen 14, 15 aufweist. Die äußeren Metalllagen 13 weisen Kontaktflächen 12 auf, in deren Mitte jeweils eine sich über die gesamte Dicke der Leiterplatte erstreckende Bohrung endet. Die inneren Metalllagen sind jeweils zumindest im Bereich zwischen den Kontaktflächen 12 der beiden Außenseiten entweder über eine leitfähige Auskleidung der Bohrung oder über nicht gezeigte, sich zwischen den Metalllagen erstreckende Vias elektrisch mit den Kontaktflächen 12 verbunden.

Fig. 3c zeigt eine Struktur der äußeren Metalllage 13. Hierbei erstrecken sich jeweils zwischen gegenüberliegenden Kontaktflächen 12, die gleichartigen Anschlüssen der Anschlussleiste 4 der beiden Teilplatinen zugeordnet sind, eine Leiterbahn, die die beiden Kontaktflächen miteinander verbindet. Diese Struktur wird für beide äußere Metalllagen 13 realisiert.

Da die den Endpunkten der Reihenschaltung der Kondensatorbänke zugeordneten Kontaktflächen in der Regel die höchste Stromtragfähigkeit aufweisen müssen, weil hier die Spannungsquelle angeschlossen wird, reichen die Leiterbahnen der äußeren Metalllage nicht aus, um die im Betrieb auftretenden Ströme zuverlässig und dauerhaft zu leiten. Daher werden in den inneren Metalllagen 14, 15 weitere Leiterbahnen zur Verbinden der entsprechenden Anschlusskontakte 12 vorgesehen. Eine erste Metalllage 14 ist in Fig. 3b gezeigt und weist dabei lediglich eine Leiterbahnstruktur auf, die zwei gegenüberliegende Kontaktflächen miteinander elektrisch verbindet, die einem der Anschlüsse der Spannungsquelle zugeordnet sind. Diese Leiterbahnenstruktur nimmt einen möglichst großen Raum innerhalb der Metalllage 14 ein, um eine Leiterbahn zwischen den Kontaktflächen mit maximaler Stromtragfähigkeit bereitzustellen. Die anderen Kontaktflächen bleiben hierbei unverbunden. Entsprechend weist eine in Fig. 3d gezeigte zweite Metalllage 15 lediglich eine Leiterbahnstruktur auf, die zwei gegenüberliegende Kontaktflächen miteinander elektrisch verbindet, die dem anderen Anschluss der Spannungsquelle zugeordnet sind. Diese Leiterbahnenstruktur nimmt ebenfalls einen möglichst großen Raum innerhalb der Metalllage 15 ein, um eine Leiterbahn zwischen den Kontaktflächen mit maximaler Stromtragfähigkeit bereitzustellen.

Innerhalb der Mehrlagen-Leiterplatte werden direkt benachbart zueinander so viele gleichartige erste Metalllagen 14 angeordnet, dass die Stromtragfähigkeit der Anordnung für den maximal zulässigen Strom der Spannungsquelle ausreicht. Auch die zweiten Metalllagen 15 werden direkt benachbart zueinander und in gleicher Anzahl angeordnet. Auf diese Weise entsteht eine Verbindungsplatine 10 mit vorteilhaft geringer Impedanz.

Der Fachmann versteht, dass die Reihenfolge und Anordnung der Kontaktflächen 12 innerhalb der Verbindungsplatine 10 beziehungsweise der Anschlussleisten 4 der Teilplatinen 2 auch anders als hier beispielhaft gezeigt gestaltet werden kann.

### BEZUGSZEICHENLISTE

- 1: Zwischenkreisanordnung
- 2: Teilplatine
- 3: Kapazitätsbank
- 4: Anschlussleiste
- 5: Kondensator
- 6: Leistungsmodul
- 7: Stromsensor
- 8: Steuerung
- 9: Phasenanschluss
- 10: Verbindungsplatine
- 11: Bohrung
- 12: Kontaktfläche
- 13: Metalllage
- 14: Metalllage
- 15: Metalllage
- 20: Drossel
- 21: Kondensator

## Patentansprüche

1. Zwischenkreisanordnung (1), umfassend:
- baugleiche erste und zweite Teilplatinen (2) mit einer Reihenschaltung von mindestens zwei Kapazitätsbänken (3), wobei die Teilplatinen (2) jeweils eine Anschlussleiste (4) mit jeweils einem positiven Zwischenkreisanschluss, einem negativen Zwischenkreisanschluss, einem Mittenanschluss aufweisen,
eine Verbindungsplatine (10) zur elektrischen Verbindung jeweiliger Anschlüsse der Anschlussleisten (4) beider Teilplatinen (2) miteinander, **dadurch gekennzeichnet, dass**
die Verbindungsplatine (10) eine Mehrlagenplatine mit zwei äußeren Metalllagen (13) und mindestens zwei zwischen den äußeren Metalllagen (13) angeordneten inneren Metalllagen (14, 15) ist, wobei die äußeren Metalllagen (13) eine elektrische Verbindung jeweils zwischen korrespondierenden Anschlüssen der Anschlussleisten (4) der beiden Teilplatinen (2) aufweisen, und
wobei mindestens eine erste Metalllage (14) der inneren Metalllagen nur eine elektrische Verbindung der positiven Zwischenkreisanschlüsse der beiden Teilplatinen (2) und mindestens eine zweite Metalllage (15) der inneren Metalllagen nur eine elektrische Verbindung der negativen Zwischenkreisanschlüsse der beiden Teilplatinen (2) aufweisen.

2. Zwischenkreisanordnung (1) nach Anspruch 1, wobei die Teilplatinen (2) eine Reihenschaltung von vier Kapazitätsbänken (3), sowie deren Anschlussleisten (4) weiterhin einen positiven Halbanschluss und einen negativen Halbanschluss aufweisen, und wobei die äußeren Metalllagen (13) weiterhin eine elektrische Verbindung jeweils zwischen den positiven Halbanschlüssen und zwischen den negativen Halbanschlüssen der beiden Teilplatinen (2) aufweisen.

3. Zwischenkreisanordnung (1) nach Anspruch 1 oder 2, wobei die Verbindungsplatine (10) elektrische Kontaktflächen (12) mit Bohrungen (11) aufweist, über die die Verbindungplatine (10) jeweils mit den Teilplatinen (2) verschraubbar und dadurch elektrisch kontaktierbar ist.

4. Zwischenkreisanordnung (1) nach Anspruch 3, wobei eine Verschraubung der Verbindungsplatine (10) mit den jeweiligen Teilplatinen (2) zusätzlich zur Halterung der Zwischenkreisanordnung (1) in einem Gehäuse oder auf einer Leiterplatte dient.

5. Zwischenkreisanordnung (1) nach einem der vorangehenden Ansprüche, wobei auf gegenüberliegenden Seiten jeder der beiden Teilplatinen (2) jeweils eine Anschlussleiste (4), insbesondere auf gleicher Höhe zueinander, angeordnet ist.

6. Zwischenkreisanordnung (1) nach einem der vorangehenden Ansprüche, wobei die Teilplatinen (2) weiterhin mindestens eine Brückenschaltung aufweisen, dessen Eingangsanschlüsse mit den Zwischenkreisanschlüssen der Teilplatine verbunden sind.

7. Zwischenkreisanordnung (1) nach einem der vorangehenden Ansprüche, wobei jeweils Kabelschuhe mit Anschlussleitungen zumindest mit dem positiven und dem negativen Zwischenkreisanschluss verschraubt sind.

8. Zwischenkreisanordnung (1) nach einem der vorangehenden Ansprüche, wobei die Verbindungsplatine (10) eine Mehrzahl innerer Metalllagen (14, 15) aufweist, die zueinander benachbart angeordnet sind, und über die die positiven Zwischenkreisanschlüsse der beiden Teilplatinen miteinander verbunden sind.

9. Wechselrichter mit einer Zwischenkreisanordnung (1) nach einem der vorangehenden Ansprüche.

10. Wechselrichter nach Anspruch 9, wobei die Teilplatinen (2) jeweils mindestens eine Brückenschaltung aufweisen.

11. Wechselrichter nach Anspruch 9, wobei die Teilplatinen (2) jeweils genau drei Brückenschaltungen aufweisen.

12. Wechselrichter nach Anspruch 11, wobei auf jeder Teilplatine (2) jeweils zwei der Brückenschaltungen einer gemeinsamen Phase (L1, L2, L3) eines dreiphasigen Wechselspannungsausgangs zugeordnet sind.

## Claims

1. An intermediate circuit arrangement (1), comprising:
- structurally identical first and second partial circuit boards (2) comprising a series connection of at least two capacitor banks (3), wherein the partial circuit boards (2) each comprise a terminal strip (4) with in each case a positive intermediate circuit connection, a negative intermediate circuit connection and a center connection,
a connecting circuit board (10) for electrically connecting respective connections of the terminal strips (4) of the two partial circuit boards (2) to one another,
**characterised in that** the connecting circuit board (10) is a multilayer circuit board comprising two outer metal layers (13) and at least two inner metal layers (14, 15) arranged between the outer metal layers (13), wherein the outer metal layers (13) each comprise an electrical connection between corresponding connections of the terminal strips (4) of the two partial circuit boards (2), and
wherein at least one first metal layer (14) of the inner metal layers comprises only an electrical connection of the positive intermediate circuit connections of the two partial circuit boards (2) and at least one second metal layer (15) of the inner metal layers comprises only an electrical connection of the negative intermediate circuit connections of the two partial circuit boards (2).

2. The intermediate circuit arrangement (1) as claimed in claim 1, wherein the partial circuit boards (2) comprise a series connection of four capacitor banks (3), wherein their terminal strips (4) furthermore comprise a positive half-connection and a negative half-connection, and wherein the outer metal layers (13) furthermore comprise a respective electrical connection between the positive half-connections and between the negative half-connections of the two partial circuit boards (2).

3. The intermediate circuit arrangement (1) as claimed in claim 1 or 2, wherein the connecting circuit board (10) comprises electrical contact surfaces (12) containing bores (11), via which the connecting circuit board (10) can be screwed in each case to the partial circuit boards (2) and thereby be put into electrical contact therewith.

4. The intermediate circuit arrangement (1) as claimed in claim 3, wherein a screw connection of the connecting circuit board (10) to the respective partial circuit boards (2) additionally serves to hold the intermediate circuit arrangement (1) in a housing or on a printed circuit board.

5. The intermediate circuit arrangement (1) as claimed in one of the preceding claims, wherein a respective terminal strip (4) is arranged, in particular level with one another, on opposing sides of each of the two partial circuit boards (2).

6. The intermediate circuit arrangement (1) as claimed in one of the preceding claims, wherein the partial circuit boards (2) furthermore comprise at least one bridge circuit, the input connections of which are connected to the intermediate circuit connections of the partial circuit board.

7. The intermediate circuit arrangement (1) as claimed in one of the preceding claims,
wherein cable lugs are screwed in each case to connection lines at least at the positive and the negative intermediate circuit connection.

8. The intermediate circuit arrangement (1) as claimed in one of the preceding claims, wherein the connecting circuit board (10) comprises a plurality of inner metal layers (14, 15) that are arranged adjacent to one another and via which the positive intermediate circuit connections of the two partial circuit boards are connected to one another.

9. An inverter comprising an intermediate circuit arrangement (1) as claimed in one of the preceding claims.

10. The inverter as claimed in claim 9, wherein the partial circuit boards (2) each comprise at least one bridge circuit.

11. The inverter as claimed in claim 9, wherein the partial circuit boards (2) each comprise exactly three bridge circuits.

12. The inverter as claimed in claim 11, wherein on each partial circuit board (2) two of the bridge circuits are assigned to a respective common phase (L1, L2, L3) of a three-phase AC voltage output.

## Revendications

1. Dispositif de circuit intermédiaire (1), comprenant :
- des première et deuxième platines partielles (2) de construction identique avec un montage en série d'au moins deux bancs de capacité (3), les platines partielles (2) présentant chacune une barrette de connexion (4) avec respectivement une connexion de circuit intermédiaire positive, une connexion de circuit intermédiaire négative, une connexion centrale,
une platine de connexion (10) pour la connexion électrique de bornes respectives des barrettes de connexion (4) des deux platines partielles (2) entre elles, **caractérisée en ce que** la platine de connexion (10) est une platine multicouche avec deux couches métalliques extérieures (13) et au moins deux couches métalliques intérieures (14, 15) disposées entre les couches métalliques extérieures (13), les couches métalliques extérieures (13) présentant une connexion électrique respectivement entre des bornes correspondantes des barrettes de connexion (4) des deux platines partielles (2), et
au moins une première couche métallique (14) des couches métalliques intérieures ne présentant qu'une liaison électrique des connexions de circuit intermédiaire positives des deux platines partielles (2) et au moins une deuxième couche métallique (15) des couches métalliques intérieures ne présentant qu'une liaison électrique des connexions de circuit intermédiaire négatives des deux platines partielles (2).

2. Dispositif de circuit intermédiaire (1) selon la revendication 1, dans lequel les platines partielles (2) présentent un montage en série de quatre bancs de capacité (3), ainsi que leurs barrettes de connexion (4) présentent en outre une demi-connexion positive et une demi-connexion négative, et dans lequel les couches métalliques extérieures (13) présentent en outre une connexion électrique respectivement entre les demi-connexions positives et entre les demi-connexions négatives des deux platines partielles (2).

3. Dispositif de circuit intermédiaire (1) selon la revendication 1 ou 2, dans lequel la platine de connexion (10) présente des surfaces de contact électrique (12) avec des trous (11) par lesquels la platine de connexion (10) peut être vissée respectivement avec les platines partielles (2) et peut ainsi être mise en contact électrique.

4. Dispositif de circuit intermédiaire (1) selon la revendication 3, dans lequel un vissage de la platine de connexion (10) avec les platines partielles (2) respectives sert en outre à maintenir le dispositif de circuit intermédiaire (1) dans un boîtier ou sur une carte de circuits imprimés.

5. Dispositif de circuit intermédiaire (1) selon l'une des revendications précédentes, dans lequel une barrette de connexion (4) est disposée sur les côtés opposés de chacune des deux platines partielles (2), notamment à la même hauteur l'une par rapport à l'autre.

6. Dispositif de circuit intermédiaire (1) selon l'une des revendications précédentes, dans lequel les platines partielles (2) présentent en outre au moins un circuit en pont dont les bornes d'entrée sont reliées aux bornes de circuit intermédiaire de la platine partielle.

7. Dispositif de circuit intermédiaire (1) selon l'une des revendications précédentes, dans lequel des cosses d'extrémité avec des lignes de raccordement sont respectivement vissées au moins avec la connexion de circuit intermédiaire positive et la connexion de circuit intermédiaire négative.

8. Dispositif de circuit intermédiaire (1) selon l'une des revendications précédentes, dans lequel la platine de connexion (10) présente une pluralité de couches métalliques intérieures (14, 15) qui sont disposées de manière adjacente les unes aux autres et par lesquelles les connexions de circuit intermédiaire positives des deux platines partielles sont reliées entre elles.

9. Onduleur avec un dispositif de circuit intermédiaire (1) selon l'une des revendications précédentes.

10. Onduleur selon la revendication 9, dans lequel les platines partielles (2) présentent chacune au moins un circuit en pont.

11. Onduleur selon la revendication 9, dans lequel les platines partielles (2) présentent chacune exactement trois circuits en pont.

12. Onduleur selon la revendication 11, dans lequel, sur chaque platine partielle (2), deux des circuits en pont sont respectivement affectés à une phase commune (L1, L2, L3) d'une sortie de tension alternative triphasée.'
